# EUROPÄISCHE PATENTANMELDUNG

(11) **EP 4 744 557 A1**
(43) Veröffentlichungstag der Anmeldung: **20.05.2026**
(21) Anmeldenummer: 25208465.2
(22) Anmeldetag: 14.10.2025
(51) Int. Cl.: A47J 43/04, G06F 3/16, H03G 3/32

(54) **VERFAHREN UND STEUEREINHEIT ZUM BETREIBEN EINES GERÄTESYSTEMS, HAUSHALTGERÄT UND GERÄTESYSTEM**

(30) Priorität: 19.11.2024 LU 103456
(71) Anmelder: Miele & Cie. KG, 33332 Gütersloh (DE)
(72) Erfinder: Köpp, Lukas, 33378 Rheda-Wiedenbrück (DE)

(57) **Zusammenfassung**

Die Erfindung betrifft ein Verfahren zum Betreiben eines Gerätesystems (100), das mindestens ein Haushaltgerät (102) und ein mit dem mindestens einen Haushaltgerät (102) datenübertragungsfähig gekoppeltes mobiles Endgerät (104) aufweist, wobei das Verfahren die folgenden Schritte umfasst: Einlesen einer Lautstärkeinformation von dem mobilen Endgerät (104), wobei die Lautstärkeinformation eine aktuelle Lautstärke einer Medienwiedergabe durch das mobile Endgerät (104) repräsentiert; Bestimmen einer aktuellen Betriebslautstärke des mindestens einen Haushaltgerätes (102) unter Verwendung mindestens einer Geräteinformation des Haushaltgerätes (102), wobei die Geräteinformation eine Korrelation zwischen einer Leistungsstufe und/oder einer Betriebsart des Haushaltgerätes (102) und einem Lautstärkewert des Haushaltgerätes (102) umfasst; Einstellen einer Medienwiedergabe des mobilen Endgerätes (104) abhängig von der Lautstärkeinformation und der aktuellen Betriebslautstärke mittels eines Steuersignals.

## Beschreibung

Die Erfindung betrifft ein Verfahren und eine Steuereinheit zum Betreiben eines Gerätesystems, ein Haushaltgerät und ein Gerätesystem.

Bei Tätigkeiten im Haushalt konsumieren viele Menschen mediale Inhalte, wie beispielsweise Musik und Podcasts. Einige Haushaltgeräte, wie beispielsweise Staubsauger, Küchenmaschinen und Abzugshabe erzeugen während der Nutzung Geräusche, die den Genuss der medialen Inhalte stören können. Um den Inhalten weiter folgen zu können, erhöhen die Nutzer beispielsweise aktiv die Lautstärke oder pausieren die Wiedergabe.

Der hier vorgestellte Ansatz stellt sich die Aufgabe, ein verbessertes Verfahren und eine verbesserte Steuereinheit zum Betreiben eines Gerätesystems, ein verbessertes Haushaltgerät und ein verbessertes Gerätesystem zu schaffen.

Erfindungsgemäß wird diese Aufgabe durch ein Verfahren und eine Steuereinheit zum Betreiben eines Gerätesystems, ein Haushaltgerät und ein Gerätesystem mit den Merkmalen der Hauptansprüche gelöst. Vorteilhafte Ausgestaltungen und Weiterbildungen der Erfindung ergeben sich aus den nachfolgenden Unteransprüchen.

Durch die Kopplung bzw. Möglichkeit zur Steuerung der Medienwiedergabe entsprechend der persönlichen Vorlieben des Nutzers, können manuelle oder sprachliche Steuerungen der Medienwiedergabe für den Nutzer während der Arbeiten mit Haushaltsgeräten überflüssig gemacht werden. Das bedeutet, dass vorteilhafterweise auf eine manuelle Interaktion mit den Geräten, zum Beispiel auch nassen oder dreckigen Händen, verzichtet werden kann. Weiterhin kann auf Sprachkommandos verzichtet werden. Die Medienwiedergabe kann optimal an durch Haushaltgerätebetrieb beeinflusste Umgebungsbedingungen angepasst werden.

Es wird ein Verfahren zum Betreiben eines Gerätesystems vorgestellt, das mindestens ein Haushaltgerät und ein mit dem mindestens einen Haushaltgerät datenübertragungsfähig gekoppeltes mobiles Endgerät aufweist. Das Verfahren umfasst einen Schritt des Einlesens einer Lautstärkeinformation von dem mobilen Endgerät, wobei die Lautstärkeinformation eine aktuelle Lautstärke einer Medienwiedergabe durch das mobile Endgerät repräsentiert. Weiterhin umfasst das Verfahren einen Schritt des Bestimmens einer aktuellen Betriebslautstärke des mindestens einen Haushaltgerätes unter Verwendung mindestens einer Geräteinformation des Haushaltgerätes, wobei die Geräteinformation eine Korrelation zwischen einer Leistungsstufe und zusätzlich oder alternativ einer Betriebsart des Haushaltgerätes und einem Lautstärkewert des Haushaltgerätes umfasst, und einen Schritt des Einstellens einer Medienwiedergabe des mobilen Endgerätes abhängig von der Lautstärkeinformation und der aktuellen Betriebslautstärke mittels eines Steuersignals.

Es muss nicht zwingend ein mobiles Endgerät zu Wiedergabe der Medien genutzt werden, oder involviert sein. Auch die Wiedergabe des TV-Sounds auf bspw. einem Lautsprecher bzw. einem smarten Mediensystem kann angepasst werden, wenn das Lautsprecher-System (oder auch ein anderes Herstellersystem) die aktuellen Lautstärkeinformationen für das steuernde System zur Verfügung stellen kann (Backend-Kopplung zweier Systeme). Dies gilt auch für alle folgenden Erwähnungen des mobilen Endgeräts.

Das Gerätesystem kann demnach in einem Haushalt angeordnet sein. Das Haushaltgerät kann beispielsweise als ein Reinigungsgerät, ein Getränkeautomat oder als ein Gargerät ausgeführt sein. Weiterhin kann das Haushaltgerät beispielsweise als ein Kleingerät realisiert sein. Das mobile Endgerät kann beispielsweise als ein Smartphone oder als ein Tablet realisiert sein. Durch das Verfahren kann vorteilhafterweise eine adaptive Lautstärkeregelung erfolgen, sodass ein Nutzerkomfort verbessert werden kann. Die Betriebslautstärke kann beispielsweise mit einer Leistungsstufe des Haushaltgerätes zusammenhängen. Durch das Verfahren kann die Lautstärke der Medienwiedergabe vorteilhafterweise automatisiert und abhängig von aktuellen Umgebungsgeräuschen angepasst werden. Die Medienwiedergabe kann beispielsweise abgespielte Musik oder ein Hörbuch sein, dem der Nutzer folgt. Vorteilhafterweise kann auf eine manuelle Interaktion des Nutzers mit seiner Medienwiedergabe während der Nutzung von geräuschintensiven Haushaltsgeräten verzichtet werden. Weiterhin können wiederholte und nicht verstandene Sprachkommandos zur Steuerung der Medienwiedergabe an beispielsweise Sprachassistenten während der Nutzung von Haushaltsgeräten vermieden werden.

Gemäß einer Ausführungsform kann im Schritt des Einstellens eine adaptierte Lautstärke der Medienwiedergabe ermittelt werden und zusätzlich oder alternativ kann die Medienwiedergabe pausiert oder fortgesetzt werden, um die Medienwiedergabe einstellen zu können. Vorteilhafterweise kann dadurch verhindert werden, dass der Nutzer Teile der Medienwiedergabe verpasst und diese Teile beispielsweise erneut abspielen muss. Weiterhin kann dadurch erreicht werden, dass ein Lautstärkepegel im Hinblick auf beispielsweise benachbarte Wohnungen in einem akzeptablen Rahmen bleibt und somit eine Lärmbelästigung anderer vermieden werden kann.

Weiterhin kann im Schritt des Einstellens die adaptierte Lautstärke der Medienwiedergabe auf einen durch einen Nutzer vorgegebenen Lautstärkenhöchstwert eingestellt werden, wenn die adaptierte Lautstärke den Lautstärkenhöchstwert übersteigt. Dadurch kann verhindert werden, dass die Medienwiedergabe für den Nutzer zu laut eingestellt wird, wenn dieser eine maximal abzuspielende Medienlautstärke vorgegeben hat.

Im Schritt des Einstellens kann die Medienwiedergabe pausiert werden, wenn die adaptierte Lautstärke einen durch einen Nutzer vorgegebenen Lautstärkenhöchstwert übersteigt. Vorteilhafterweise kann der Lautstärkenhöchstwert als ein durch den Nutzer einstellbarer Grenzwert realisiert sein. Vorteilhafterweise kann der Nutzer den Lautstärkenhöchstwert frei einstellen.

Gemäß einer Ausführungsform kann im Schritt des Einstellens die aktuelle Lautstärke der Medienwiedergabe zu der adaptierten Lautstärke der Medienwiedergabe um einen Änderungsbetrag geändert werden, der abhängig von der Lautstärkeinformation und der aktuellen Betriebslautstärke definiert sein kann. Vorteilhafterweise kann durch einen geeignet definierten Änderungsbetrag der Konsum von medialen Inhalten während der Durchführung von geräuschintensiven Arbeiten im Haushalt und somit ein mediales Ergebnis für den Nutzer verbessert werden.

Ferner kann im Schritt des Bestimmens die aktuelle Betriebslautstärke unter Verwendung eines in dem Haushaltgerät angeordneten Mikrofons, alternativ auch im SmartSpeaker oder im mobilen Endgerät angeordnet, bestimmt werden. Das Mikrofon kann vorteilhafterweise auch für weitere Gerätefunktionen, wie beispielsweise für eine Sprachsteuerung oder eine Fehlererkennung verwendet werden. Vorteilhafterweise können die Schritte des Verfahrens zyklisch wiederholt ausgeführt werden, sodass beispielsweise auch auf diese Weise erkannt werden kann, wenn ein weiteres Haushaltgerät abgeschaltet wurde und die Medienlautstärke wieder reduziert werden kann.

Der hier vorgestellte Ansatz schafft ferner eine Steuereinheit, die ausgebildet ist, um die Schritte einer Variante eines hier vorgestellten Verfahrens in entsprechenden Einrichtungen durchzuführen, anzusteuern bzw. umzusetzen. Auch durch diese Ausführungsvariante der Erfindung in Form einer Vorrichtung kann die der Erfindung zugrunde liegende Aufgabe schnell und effizient gelöst werden.

Die Steuereinheit kann ausgebildet sein, um Eingangssignale einzulesen und unter Verwendung der Eingangssignale Ausgangssignale zu bestimmen und bereitzustellen. Ein Eingangssignal kann beispielsweise ein über eine Eingangsschnittstelle der Steuereinheit einlesbares Sensorsignal darstellen. Ein Ausgangssignal kann ein Steuersignal oder ein Datensignal darstellen, das an einer Ausgangsschnittstelle der Steuereinheit bereitgestellt werden kann. Die Steuereinheit kann ausgebildet sein, um die Ausgangssignale unter Verwendung einer in Hardware oder Software umgesetzten Verarbeitungsvorschrift zu bestimmen. Beispielsweise kann die Steuereinheit dazu eine Logikschaltung, einen integrierten Schaltkreis oder ein Softwaremodul umfassen und beispielsweise als ein diskretes Bauelement realisiert sein oder von einem diskreten Bauelement umfasst sein.

Von Vorteil ist auch ein Computer-Programmprodukt oder Computerprogramm mit Programmcode, der auf einem maschinenlesbaren Träger oder Speichermedium wie einem Halbleiterspeicher, einem Festplattenspeicher oder einem optischen Speicher gespeichert sein kann. Wird das Programmprodukt oder Programm auf einem Computer oder einer Steuereinheit ausgeführt, so kann das Programmprodukt oder Programm zur Durchführung, Umsetzung und/oder Ansteuerung der Schritte des Verfahrens nach einer der hier beschriebenen Ausführungsformen verwendet werden.

Es wird zudem ein Haushaltgerät mit einer Steuereinheit in einer zuvor genannten Variante vorgestellt.

Das Haushaltgerät kann beispielsweise als ein Gargerät, ein Reinigungsgerät, als ein Wrasenabzug oder beispielsweise als ein Getränkeautomat ausgeführt sein. Weiterhin kann das Haushaltgerät als ein Standgerät ausgeführt sein, wie beispielsweise ein Mixer. Auch wenn der beschriebene Ansatz anhand eines Haushaltgerätes beschrieben wird, kann der hier beschriebene Ansatz entsprechend im Zusammenhang mit einem gewerblichen oder professionellen Gerät eingesetzt werden.

Außerdem wird ein Gerätesystem mit mindestens einem Haushaltgerät in einer zuvor genannten Variante und einem mobilen Endgerät vorgestellt. Dabei können das mindestens eine Haushaltgerät und das mobile Endgerät datenübertragungsfähig miteinander gekoppelt sein.

Das mobile Endgerät kann beispielsweise als ein Smartphone, als ein Tablet oder beispielsweise als eine Smartwatch ausgeführt sein. Das mobile Endgerät kann vorteilhafterweise datenübertragungsfähig realisiert sein, um beispielsweise mittels einer Bluetooth-Verbindung oder mittels WLAN mit dem mindestens einen Haushaltgerät gekoppelt zu sein bzw. zu werden.

Ein Ausführungsbeispiel der Erfindung ist in den Zeichnungen rein schematisch dargestellt und wird nachfolgend näher beschrieben. Es zeigt
- Figur 1: eine schematische Darstellung eines Ausführungsbeispiels eines Gerätesystems;
- Figur 2: ein Ablaufdiagramm eines Ausführungsbeispiels eines Verfahrens zum Betreiben eines Gerätesystems; und
- Figur 3: ein Blockschaltbild eines Ausführungsbeispiels einer Steuereinheit.

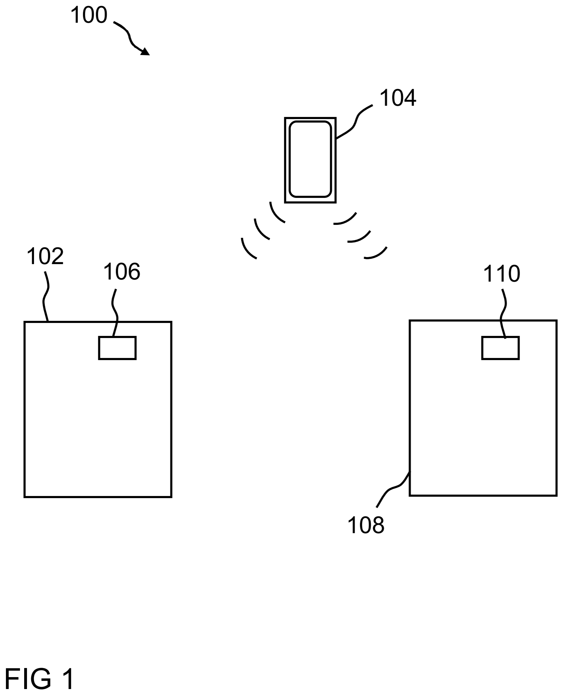

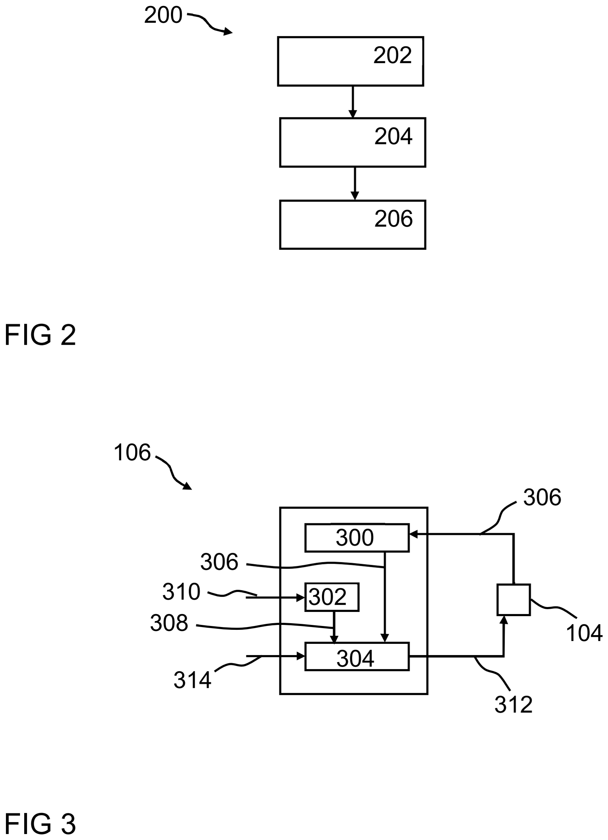

Figur 1 zeigt eine schematische Darstellung eines Ausführungsbeispiels eines Gerätesystems 100. Das Gerätesystem 100 weist mindestens ein Haushaltgerät 102 und ein mobiles Endgerät 104 auf. Das mindestens eine Haushaltgerät 102 und das mobile Endgerät 104 sind datenübertragungsfähig miteinander gekoppelt. Das Haushaltgerät 102 weist dabei eine Steuereinheit 106 auf, die ausgebildet ist, um die Schritte eines Verfahrens zum Betreiben des Gerätesystems 100 in entsprechenden Einheiten auszuführen und/oder anzusteuern. Das Verfahren wird in Figur 2 näher beschrieben.

Gemäß einem Ausführungsbeispiel weist das Gerätesystem 100 zusätzlich ein weiteres Haushaltgerät 108 auf, das dem Haushaltgerät 102 ähnelt. Das weitere Haushaltgerät 108 und das mobile Endgerät 104 sind datenübertragungsfähig miteinander gekoppelt. Optional zusätzlich sind das Haushaltgerät 102 und das weitere Haushaltgerät 108 datenübertragungsfähig miteinander gekoppelt. Auch das weitere Haushaltgerät 108 weist eine weitere Steuereinheit 110 auf. Das zuvor erwähnte Verfahren ist beispielsweise auch durch die weitere Steuereinheit 110 ausführbar.

Die Haushaltgeräte 102, 108 sind gemäß einem Ausführungsbeispiel als Großgeräte ausgeführt. Alternativ sind die Haushaltgeräte 102, 108 aber auch als Standgeräte und/oder als Kleingeräte realisierbar.

Figur 2 zeigt ein Ablaufdiagramm eines Ausführungsbeispiels eines Verfahrens 200 zum Betreiben eines Gerätesystems, das beispielsweise dem in Figur 1 beschriebenen Gerätesystem entspricht oder zumindest ähnelt. Das Verfahren 200 wird für ein Gerätesystem verwendet, das mindestens ein Haushaltgerät und ein mit dem mindestens einen Haushaltgeräts datenübertragungsfähig gekoppeltes mobiles Endgerät aufweist, um eine adaptive Lautstärkeregelung einer Medienwiedergabe des mobilen Endgerätes zu erreichen. Das Verfahren 200 umfasst dazu einen Schritt 202 des Einlesens, einen Schritt 204 des Bestimmens und einen Schritt 206 des Einstellens.

Im Schritt 202 des Einlesens wird eine Lautstärkeinformation von dem mobilen Endgerät eingelesen, wobei die Lautstärkeinformation eine aktuelle Lautstärke einer Medienwiedergabe durch das mobile Endgerät repräsentiert. Im Schritt 204 des Bestimmens wird eine aktuelle Betriebslautstärke des mindestens einen Haushaltgeräts unter Verwendung mindestens einer Geräteinformation des Haushaltgerätes bestimmt, wobei die Geräteinformation eine Korrelation zwischen einer Leistungsstufe und/oder einer Betriebsart des Haushaltgerätes und einem Lautstärkewert des Haushaltgerätes umfasst. Im Schritt 206 des Einstellens wird eine Medienwiedergabe des mobilen Endgerätes abhängig von der Lautstärkeinformation und der aktuellen Betriebslautstärke mittels eines Steuersignals eingestellt.

Gemäß einem Ausführungsbeispiel wird im Schritt 204 des Bestimmens die aktuelle Betriebslautstärke unter Verwendung eines in dem Haushaltgerät angeordneten Mikrofons bestimmt. Alternativ ist auch ein in dem mobilen Endgerät angeordnetes Mikrofon für den Schritt 204 des Bestimmens verwendbar. Beispielsweise wird im Schritt 206 des Einstellens die aktuelle Lautstärke der Medienwiedergabe zu der adaptierten Lautstärke der Medienwiedergabe um einen Änderungsbetrag geändert, der abhängig von der Lautstärkeinformation und der aktuellen Betriebslautstärke definiert ist. Das bedeutet, dass beispielsweise der Änderungsbetrag als ein definierter Differenzwert zwischen der aktuellen Betriebslautstärke und der adaptierten Lautstärke der Medienwiedergabe liegt. Die adaptierte Lautstärke wird beispielsweise im Schritt 206 des Einstellens ermittelt. Zusätzlich oder alternativ wird im Schritt 206 des Einstellens die Medienwiedergabe pausiert oder fortgesetzt, um die Medienwiedergabe einzustellen. Optional gibt ein Nutzer dazu einen Lautstärkenhöchstwert vor, auf den die adaptierte Lautstärke eingestellt wird, wenn die adaptierte Lautstärke den Lautstärkenhöchstwert übersteigt. Anders ausgedrückt gibt der Nutzer den Lautstärkenhöchstwert vor, der eine höchste auszugebende Lautstärke repräsentiert. Sofern der Lautstärkenhöchstwert eingestellt wird, wird verhindert, dass diese höchste auszugebende Lautstärke überstiegen wird. Alternativ dazu wird gemäß einem Ausführungsbeispiel im Schritt 206 des Einstellens die Medienwiedergabe pausiert, wenn die adaptierte Lautstärke den durch den Nutzer vorgegebenen Lautstärkenhöchstwert übersteigt.

In anderen Worten ausgedrückt wird mit dem beschriebenen Ansatz eine adaptive Lautstärkeregelung für eine Medienwiedergabe abhängig von Geräuschpegeln von Haushaltsgeräten ermöglicht. Durch den vorgestellten Ansatz wird ein erzeugter Geräuschpegel der Haushaltsgeräte erkannt und mit einem Status der Medienwiedergabe, bzw. dessen Lautstärke in Relation gesetzt. Dadurch wird eine Steuerung ermöglicht, beispielsweise wie sehr die Lautstärke erhöht werden soll oder ab welchem Pegel die Wiedergabe pausiert werden soll.

Dies wird gemäß einem Ausführungsbeispiel mittels einer Verknüpfung aus der aktuellen Lautstärke der Medienwiedergabe mit dem Geräuschpegel der aktuellen Leistungsstufe eines Küchengerätes und beispielsweise einer Ableitung bzw. Herleitung, um wie viel die Lautstärke der Medienwiedergabe für ein optimales Klangerlebnis angehoben werden sollte, erreicht. Diese Anhebung ist an beispielsweise einem gewissen Punkt endlich, sodass die Wiedergabe dann pausiert wird, anstatt die Lautstärke weiter zu erhöhen. Um dies zu ermöglichen, erhält die Steuereinheit für diese Funktion Zugriff auf die aktuelle Lautstärke der Medienwiedergabe. Bei smarten Mediensystemen sind diese Informationen beispielsweise über eine sogenannte 3rd Party API verfügbar. Weiterhin ist die Information vorhanden, welcher Geräuschpegel bei welcher Leistungsstufe der genutzten Haushaltsgeräte entsteht. und auch. wie sich dieser ändert, wenn mehrere Haushaltsgeräte gleichzeitig in Verwendung sind. Informationen über eine Ziellautstärke der Medienwiedergabe in Abhängigkeit vom Geräuschpegel sind beispielsweise im Haushaltgerät hinterlegt. Der Nutzer kann für seine Haushaltgeräte beispielsweise über eine entsprechende Eingabefläche einstellen, ob er die adaptive Lautstärkeanpassung nutzen möchte und das Gerätesystem, mit dem dieses geschehen soll, entsprechend koppeln. In der Konfiguration wird dem Nutzer ermöglicht, die vorgeschlagenen Einstellungen für die Lautstärkeanpassung abhängig vom Geräuschpegel der Küchengeräte und die maximale Medienlautstärke, bis zu der eine adaptive Anpassung stattfinden soll, einzustellen. Weiterhin optional weist das Haushaltgerät dazu ein Mikrofon auf oder es ist beispielsweise ein Sprachassistent nutzbar, um das Klangerlebnis basierend auf dem über die Mikrofone ermittelten Raumklang zu verbessern.

Nachfolgend ist ein Beispiel für die Umsetzung des Verfahrens 200 beschrieben:
Ein Nutzer hört Musik in Zimmerlautstärke, beispielsweise 50 dB, während er in der Küche Zutaten für den Kochprozess vorbereitet. Die Zutaten werden in der Pfanne gebraten, die Dunstabzugshaube schaltet sich ein und erzeugt dabei einen Geräuschpegel von beispielsweise 45 dB. Ein definierter Differenzwert zwischen Arbeitslärm und der Wiedergabe der Musik für ein angenehmes Musikerlebnis trotz Betriebsgeräuschen, der zum Beispiel 15 dB beträgt, wird nun herangezogen, um die Lautstärke zu erhöhen. Die Steuereinheit sendet an das gekoppelte System für die Medienwiedergabe, dass die Lautstärke auf 60 dB gesetzt werden soll, die sich aus den 45 dB Dunstabzug zuzüglich der 15 dB Differenzwert ergeben. Daraufhin wird die Lautstärke der Medienwiedergabe erhöht.

Während des Bratens häckselt der Nutzer Gemüse in einem weiteren Haushaltgerät. Dabei entsteht ein Geräuschpegel von beispielsweise 85 dB. Der Nutzer hat in seiner Konfiguration einen Lautstärkepegel von maximal 80 dB für die adaptive Lautstärkenanpassung hinterlegt. Die Steuereinheit steuert daher keine weitere Erhöhung der Lautstärke an, sondert sendet ein Kommando zur Unterbrechung der Wiedergabe. Sobald der Nutzer das Häckseln beendet hat, wird geprüft, ob und in welcher Lautstärke die Medienwiedergabe fortgesetzt werden soll. Da der Dunstabzug weiterhin läuft, wird die Lautstärke wieder auf 60 dB gesetzt und die Wiedergabe fortgesetzt. Der Nutzer beendet das Braten und die Dunstabzugshaube wird ausgeschaltet. Der Geräuschpegel in der Küche ist also nicht mehr vorhanden. Die Steuereinheit erkennt dies und setzt die Lautstärke der Medienwiedergabe wieder auf die ursprünglichen 50 dB zurück.

Figur 3 zeigt ein Blockschaltbild eines Ausführungsbeispiels einer Steuereinheit 106, die beispielsweise der in Figur 1 beschriebenen Steuereinheit entspricht und die ausgebildet ist, um ein Verfahren anzusteuern und/oder durchzuführen, wie es beispielsweise in Figur 2 beschrieben wurde. Die Steuereinheit 106 weist eine Einleseeinheit 300, eine Bestimmungseinheit 302 und eine Einstelleinheit 304 auf.

Die Einleseeinheit 300 ist dabei ausgebildet, um eine Lautstärkeinformation 306 von dem mobilen Endgerät 104 einzulesen, wobei die Lautstärkeinformation 306 eine aktuelle Lautstärke einer Medienwiedergabe durch das mobile Endgerät 104 repräsentiert. Die Bestimmungseinheit 302 ist ausgebildet, um eine aktuelle Betriebslautstärke 308 des mindestens einen Haushaltgeräts unter Verwendung mindestens einer Geräteinformation 310 des Haushaltgerätes zu bestimmen, wobei die Geräteinformation 310 eine Korrelation zwischen einer Leistungsstufe und/oder einer Betriebsart des Haushaltgerätes und einem Lautstärkewert des Haushaltgerätes umfasst. Die Einstelleinheit 304 ist ausgebildet, um eine Medienwiedergabe des mobilen Endgerätes 104 abhängig von der Lautstärkeinformation 306 und der aktuellen Betriebslautstärke 308 mittels eines Steuersignals 312 einzustellen.

Weiterhin ist die Einstelleinheit 304 gemäß einem Ausführungsbeispiel ausgebildet, um eine adaptierte Lautstärke der Medienwiedergabe zu ermitteln und/oder die Medienwiedergabe pausieren oder fortzusetzen, um die Medienwiedergabe unter Verwendung des Steuersignals 312 einzustellen. Beispielsweise stellt die Einstelleinheit 304 die adaptierte Lautstärke der Medienwiedergabe auf einen durch einen Nutzer vorgegebenen Lautstärkenhöchstwert 314 ein, wenn die adaptierte Lautstärke den Lautstärkenhöchstwert übersteigt. Alternativ dazu ist die Einstelleinheit 304 ausgebildet, um die Medienwiedergabe zu pausieren, wenn die adaptierte Lautstärke einen durch den Nutzer vorgegebenen Lautstärkenhöchstwert 314 übersteigt.

## Patentansprüche

1. Verfahren (200) zum Betreiben eines Gerätesystems (100), das mindestens ein Haushaltgerät (102) und ein mit dem mindestens einen Haushaltgerät (102) datenübertragungsfähig gekoppeltes mobiles Endgerät (104) aufweist, wobei das Verfahren (200) die folgenden Schritte umfasst:
- Einlesen (202) einer Lautstärkeinformation (306) von dem mobilen Endgerät (104), wobei die Lautstärkeinformation (306) eine aktuelle Lautstärke einer Medienwiedergabe durch das mobile Endgerät (104) repräsentiert;
- Bestimmen (204) einer aktuellen Betriebslautstärke (308) des mindestens einen Haushaltgerätes (102) unter Verwendung mindestens einer Geräteinformation (310) des Haushaltgerätes (102), wobei die Geräteinformation (310) eine Korrelation zwischen einer Leistungsstufe und/oder einer Betriebsart des Haushaltgerätes (102) und einem Lautstärkewert des Haushaltgerätes (102) umfasst;
- Einstellen (206) einer Medienwiedergabe des mobilen Endgerätes (104) abhängig von der Lautstärkeinformation (306) und der aktuellen Betriebslautstärke (308) mittels eines Steuersignals (312).

2. Verfahren (200) gemäß Anspruch 1, wobei im Schritt (206) des Einstellens eine adaptierte Lautstärke der Medienwiedergabe ermittelt wird und/oder die Medienwiedergabe pausiert oder fortgesetzt wird, um die Medienwiedergabe einzustellen.

3. Verfahren (200) gemäß Anspruch 2, wobei im Schritt (206) des Einstellens die adaptierte Lautstärke der Medienwiedergabe auf einen durch einen Nutzer vorgegebenen Lautstärkenhöchstwert (314) eingestellt wird, wenn die adaptierte Lautstärke den Lautstärkenhöchstwert (314) übersteigt.

4. Verfahren (200) gemäß Anspruch 2, wobei im Schritt (206) des Einstellens die Medienwiedergabe pausiert wird, wenn die adaptierte Lautstärke einen durch einen Nutzer vorgegebenen Lautstärkenhöchstwert (314) übersteigt.

5. Verfahren (200) gemäß einem der vorangegangenen Ansprüche, wobei im Schritt (206) des Einstellens die aktuelle Lautstärke der Medienwiedergabe zu der adaptierten Lautstärke der Medienwiedergabe um einen Änderungsbetrag geändert wird, der abhängig von der Lautstärkeinformation (306) und der aktuellen Betriebslautstärke (308) definiert ist.

6. Verfahren (200) gemäß einem der vorangegangenen Ansprüche, wobei im Schritt (204) des Bestimmens die aktuelle Betriebslautstärke (308) unter Verwendung eines in dem Haushaltgerät (102) angeordneten Mikrofons bestimmt wird.

7. Steuereinheit (106), die ausgebildet ist, um die Schritte (202, 204, 206) des Verfahrens (200) gemäß einem der vorangegangenen Ansprüche in entsprechenden Einheiten (300, 302, 304) auszuführen und/oder anzusteuern.

8. Computer-Programmprodukt mit Programmcode zur Durchführung des Verfahrens (200) nach einem der Ansprüche 1 bis 6, wenn das Computer-Programmprodukt auf einer Steuereinheit (106) gemäß Anspruch 7 ausgeführt wird.

9. Haushaltgerät (102) mit einer Steuereinheit (106) gemäß Anspruch 7.

10. Gerätesystem (100) mit mindestens einem Haushaltgerät (102, 108) gemäß Anspruch 9 und einem mobilen Endgerät (104).
